# EUROPEAN PATENT APPLICATION

(11) **EP 2 244 299 A1**
(43) Date of publication of application: **27.10.2010**
(21) Application number: 10160716.6
(22) Date of filing: 22.04.2010
(51) Int. Cl.: H01L 29/78, H01L 29/423, H01L 21/336

(54) **MOS transistor for power applications and corresponding integrated circuit and manufacturing method**

(30) Priority: 22.04.2009 IT MI20090672
(71) Applicant: STMicroelectronics S.r.l., 20041 Agrate Brianza MI (IT)
(72) Inventor: Croce, Giuseppe, I-23873, Lecco (IT); Gattari, Paolo, I-20139, Milano (IT); Paleari, Andrea, I-20043, Arcore (MB) (IT); Dundulachi, Alessandro, I-20040, VIMERCATE (MB) (IT)
(74) Representative: Maccalli, Marco

(57) **Abstract**

A MOS transistor (100) for power applications in a substrate (105) of semiconductor material, is formed by a method being integrated in a process for manufacturing integrated circuits which uses an STI technique for forming the insulating regions. The method includes the phases of forming an insulating element (127) on a top surface (112) of the substrate and forming a control electrode (128) on a free surface of the insulating element. The insulating element insulates the control electrode from the substrate. Said insulating element comprises a first portion (130) and a second portion (135). The extension of the first portion along a first direction perpendicular to the top surface is lower than the extension of the second portion along such first direction. The phase of forming the insulating element comprises generating said second portion by locally oxidizing the top surface.

## Description

The present invention relates to the integrated circuits, and particularly relates to a process for manufacturing power devices in integrated circuits.

The great majority of integrated circuits that are currently manufactured are formed by field effect transistors of the Metal-Oxide-Semiconductor type (MOS), which are produced by means of complementary manufacturing processes (CMOS). At the present time, by means of an optimized CMOS manufacturing process, it is possible to produce fast switching transistors with a high integration density.

The operative voltages managed by the MOS transistors forming an integrated circuit have values which depend on the use to which the integrated circuit itself is destined. In the integrated circuits for digital applications, such operative voltages have relatively low values, for example included in an amplitude range equals to 1.2 - 1.8 Volts. In the power applications - such as in the driving circuits for computer and printer motors, or in the audio amplifier circuits - such amplitude range may sensibly increase, and exceed 20 Volts.

The MOS transistors employed in power applications are structured in such a way to be capable of managing voltages having a high value without being affected by damaging or breaking, and sourcing high current values in an efficient way, minimizing the resistive drop across the terminals thereof. Among the MOS transistors for power applications presently available on the market which are capable of managing high voltages, there are enumerated the so-called Drift-MOS (DMOS) transistors, the Double Diffused MOS (DDMOS) transistors and the Drain Extended MOS (DEMOS) transistors. Such transistors have in common the presence of an extended collection region characterized by a relatively low doping level (e.g., 10¹⁶ cm⁻³ - 10¹⁷ atoms/cm⁻³); within said region, denoted with the term of drain extension region, a highly doped (e.g., 10²⁰ atoms/cm⁻³) contact region is formed. The drain extension region forms a junction of the n-/p type with the body region of the transistor wherein the channel is formed. This junction is inverse-biased during the normal operative conditions of the transistor, and results to be covered by the control electrode, which has the double function of modulating the amount of electric current flowing in the channel when the transistor is on, and extending the electric field lines of the abovementioned junction when the transistor is off, for the purpose of increasing the operative voltage which can be tolerated by the device.

Without descending into known details, all the transistors of such type exhibit an asymmetric structure, due to the presence of the drain extension region; particularly, the electric field which is formed close to the junction between the drain extension region and the region wherein the channel is formed in response to the application of high voltage differences is able to distribute itself along a longer path. As a consequence, a transistor for power applications exhibits a relatively low channel resistance when it is in conduction, and a high breakdown voltage.

In order to reduce the manufacturing costs and the silicon area occupation, both MOS transistors for power applications adapted to manage high operative voltages and high integration density MOS transistors designed for managing reduced operative voltages may be integrated on a same silicon chip. For example, a single chip may integrate a driving circuit for a motor controlled by a digital control circuit; in this case, since the digital control circuit typically has to manage low voltage signal, such circuit may be implemented by means of normal MOS transistors, while the driving circuit will be formed by MOS transistors for power applications, such as by DEMOS transistors.

In order to minimize the production costs, the manufacturing steps required for manufacturing a DEMOS transistor are typically integrated in a CMOS manufacturing flux.

For example, according to a solution known in the art, the drain extension region of an n-channel DEMOS transistor may be implemented forming an n-well in a region of the p type (substrate of the integrated circuit or epitaxial layer grown on the starting substrate). The source contact region is formed by means of ionic implantation of donor elements in the region of the p type (body). The drain contact region of the DEMOS transistor is formed in the end of the drain extension region opposite to the source contact region; typically, also such contact region is formed by means of ionic implantation of donor elements, and particularly at the same time of the formation of the source contact region. An insulating material layer is formed on the surface of the chip between the source contact region and the drain contact region; the gate terminal is formed by means of a conductive material layer - such as polysilicon - located above such insulating layer.

Since during the operation of the DEMOS transistor the drain is typically brought to a voltage higher than the voltage the gate terminal is brought to, the thickness of such layer is increased close to the drain region for avoiding any occurrence of breakings in the insulating material layer. For this purpose, before the formation of the gate oxide (which in the standard MOS transistors coincides with the insulating material layer in its totality), an additional insulating region is formed in the drain extension region - and particularly close to the drain contact region - having a relatively high thickness, higher than the oxide gate thickness.

Particularly, according to a known solution, the additional insulating region is typically implemented by means of the insulating technique used in the CMOS manufacturing processes. In the advanced CMOS processes, having minimal critical sizes lower than 0.25 µm, the additional insulating region is formed by means of the insulating technique denoted "Shallow Trench Isolation" (STI). As it is known to the skilled technicians, such technique provides for the formation of the additional insulating region by means of the formation of a trench in the silicon forming the drain extension region. Such trench is filled by depositing an insulating material layer, such as silicon dioxide. The STI technique is normally used in the modem CMOS manufacturing processes for forming the insulating zones between adjacent MOS transistors in the digital circuits; thanks to the use of such technique, it is possible to obtain very high integration densities.

Consequently, the steps of the process required to form the additional insulating regions in the DEMOS transistors (or, more generally, in the transistor for power applications adapted to manage high voltages) may be integrated in a CMOS manufacturing process without high additional costs, being sufficient modifying the masks used during the formation of the insulating zones between adjacent transistors for defining the position and the shape of the desired additional insulating regions.

A further potential advantage obtainable using the STI technique for the formation of the additional insulating zones regards the possibility of obtaining drain extension regions relatively extended without having to increase the planar size of the transistors. Indeed, since the STI technique is typically used for forming insulating zones between adjacent MOS transistors, an additional insulating region implemented with the STI technique extends in depth in the drain extension region by a non-negligible amount. For this reason, the path of the carriers responsible for the conduction of a DEMOS transistor of such type does not extend along a straight line, parallel to the chip surface. As a consequence, the length of the conductive path of a DEMOS transistor of such type is given by the length of the active zone of the transistor (i.e., the distance between the drain contact region and the source contact region) plus the vertical extension of the additional insulating region within the drain extension region (*i.e.,* the distance between the chip surface and the bottom of the additional insulating region).

However, the use of the STI technique for the formation of transistor for power applications adapted to manage high voltages may be disadvantageous under different circumstances.

One of the most important parameters which characterize an active DEMOS transistor (i.e., when the transistor is in the conduction state, and it is crossed by current) is its electric resistance, denoted conduction resistance. Since the voltage values are high, the current flowing through an active DEMOS typically has a high value; as a consequence, it may be important that the conduction resistance is kept to a value that is as low as possible for minimizing the power dissipation in the device. However, the value of such resistance increases with the increasing of the drain extension region portion extending along the vertical direction, *i.e.,* perpendicularly to the surface of the chip. As a consequence, using an STI technique for realizing an additional insulating region - which, as previously described, extends in depth in the drain extension region by a non-negligible amount - may increase the conduction resistance value.

A further increasing of the conduction resistance due to the use of the STI technique may be caused by a reduction of the mobility of the electrons in the silicon close to the additional insulating region. Such mobility reduction is mainly caused by the stress to which the silicon is subjected during the formation of the additional insulating regions (formation of the trenches, fill and subsequent thermal treatments).

Moreover, the lateral walls of an additional insulating region obtained by means of the STI technique extends along a direction that is substantially perpendicular to the surface of the substrate, and thus perpendicular to the trajectory traveled by the electrons injected in the channel by the source region. As a consequence, with this structure an electron provided with a sufficiently high kinetic energy (hot electron) will have a non zero probability to cross the lateral wall of the additional insulating region, and remaining trapped within the oxide field. In greater detail, the electric field that is generated in the device during the operation has a component transversal to the electron trajectory which exhibits very low values in module thanks to the particular conformation of the lateral walls; as a consequence, the electric field may be not capable of effectively opposing to the injection phenomena of the carriers from the silicon to the oxide region. This phenomenon may jeopardize the conduction resistance in a negative way, and altering the value of such resistance in a significant way.

In view of the state of the art herein illustrated, it is an object of the present invention to overcome the above mentioned drawbacks.

Different aspects of the solution according to an embodiment of the present invention are indicated in the independent claims.

Advantageous embodiments are described in the dependent claims.

Particularly, a method for forming a MOS transistor for power applications in a semiconductor material substrate is proposed. Such method is integrated in a process for manufacturing integrated circuits which makes use of a STI technique for the formation of insulating regions. The method includes the steps of forming an insulating element on a top surface of the substrate and forming a control electrode on a free surface of the insulating element. The insulating element insulates the control electrode from the substrate. Such insulating element comprises a first portion and a second portion. The extension of such first portion along a first direction perpendicular to the top surface is lower than the extension of the second portion along such first direction. The step of forming the insulating element comprises generating such second portion by locally oxidizing the top surface.

A further aspect provides a MOS transistor for power applications.

A still further aspect of the present invention provides an integrated circuit.

The solution according to one or more embodiments of the invention, as well as further features and advantages thereof will be best understood by reference to the following detailed description, given purely by way of a non-restrictive indication, to be read in conjunction with the accompanying drawings. In this respect, it is expressly intended that the figures are not necessary drawn to scale and that, unless otherwise indicated, they are merely intended to conceptually illustrate the structures and procedures described herein. Particularly:
**Figure 1** schematically shows a sectional view of an n-channel DEMOS transistor according to an embodiment of the present invention, and
**Figures 2A-2N** illustrate several phases of a process for manufacturing the DEMOS transistor illustrated in **Figure 1** according to an embodiment of the present invention.

In the following of the present description, similar or identical elements illustrated in different figures will be identified with the same references. Moreover, the impurity concentrations (electrically active doping elements) included in the semiconductor materials will be quantified in an indicative way by adopting the following conventions: with the terms "p" and "n" are indicated materials with an "average" concentration of acceptors and donors, respectively, with the terms "p-" and "n-" are indicated materials with a "light" concentration of acceptors and donors, respectively, while with the terms "p+" and "n+" are indicated materials with a "high" concentration of acceptors and donors, respectively.

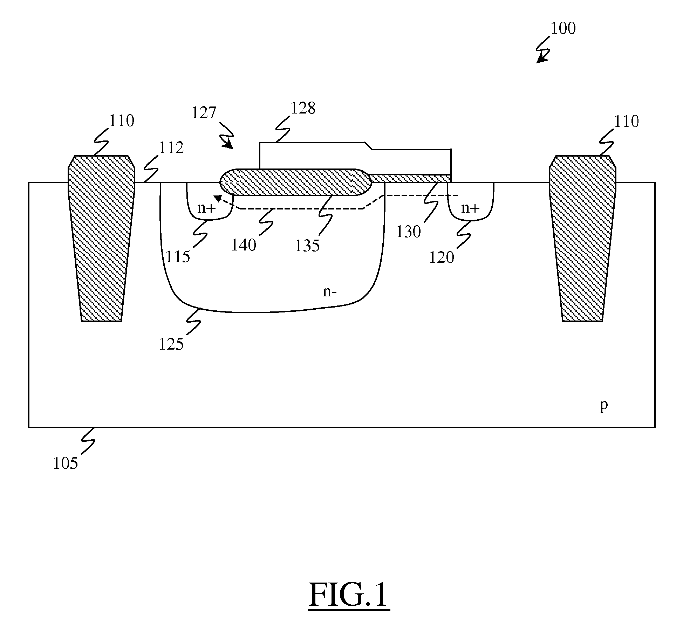

With reference to **Figure 1****,** a sectional view of an n-channel DEMOS transistor **100** obtainable with a manufacturing process according to an embodiment of the present invention is illustrated.

The DEMOS transistor **100** is integrated in a chip of semiconductor material, for example silicon. In the same chip may be integrated also transistors of different type (not illustrated in the figure), such as MOS transistor for low voltage digital applications, complementary bipolar transistors (NPN and PNP) and passive components (resistors, diodes and capacitors). With the reference **105** it is indicated a portion of the chip acting as a substrate (body) for the DEMOS transistor **100.** The substrate **105** is formed by p-doped silicon.

The DEMOS transistor **100** may be insulated from the other devices integrated in the chip by means of insulating regions **110** formed by insulating material, such as silicon oxide (field oxide), which extends in depth in the substrate **105** starting from the top surface, identified with the reference **112.** For example, the insulating region **110** may be realized by means of the STI technique described in the introduction of the present document.

The DEMOS transistor **100** comprises a drain contact region **115** and a source contact region **120,** both formed by doped silicon of the n+ type. Particularly, while the source contact region **120** is directly formed in the substrate **105** (of the p type) - or in a dedicated region of the p type implanted in the substrate -, the drain contact region **115** is formed within a drain extension region **125** formed by silicon of the n- type.

An insulating element **127** formed by silicon oxide is located on the surface **112** between the drain contact region **115** and the source contact region **120.** The insulating element **127** is at least partially covered by a gate electrode **128** formed by a semiconductor or conductor material layer - such as properly doped polycrystalline silicon (polysilicon).

The insulating element **127** is formed by two distinct elements having different thicknesses and functions. A first portion, indicated in the figure with the reference **130,** substantially extends from a border of the source contact region **120** until reaching or covering a portion of the drain extension region **125.** Such element is properly referred to as gate oxide. A second portion of the insulating element **127,** identified in figure with the reference **135** and denoted with the term of additional insulating region, extends from the end of the gate oxide **130** which overtops the drain extension region **125** until reaching the drain contact region **115.**

As already described in the introduction of the present document, in order to avoid the occurrence of break down in the insulating element **127,** and thus the occurrence of faults in a transistor for power applications such as the DEMOS transistor **100,** the thickness of the insulating element **127** close to the drain contact region **115** is made to be sufficiently high. As a consequence, while the thickness of the gate oxide **130** may be of the same order of magnitude of the thickness of the gate oxide of a MOS transistor for low voltage applications, the thickness of the additional insulating region **135** is higher. Furthermore, the shape of the additional insulating region **135** and the extension of such region within the drain extension region **125** of the DEMOS transistor **100** may be designed for the purpose of overcoming the known drawbacks which usually affect the conduction resistances of the DEMOS transistors.

Particularly, the additional insulating region **135** of the proposed DEMOS transistor **100** may extend within the drain extension region **125** to a lower depth compared to the depth reached by an equivalent additional insulating region obtained by means of the conventional techniques commonly used in the CMOS fabrication processes, *i.e.,* by means of the STI technique. Furthermore, unlike the additional insulating regions obtained by means of the STI technique, the shape of the additional insulating region **135** of the proposed DEMOS transistor **100** may be tapered at the lateral ends, *i.e.,* at the ends which are near or in contact with the portion **130** and with the drain contact region **115.**

When the bias voltage applied to the gate electrode **128** is sufficiently high, in the substrate portion **105** beneath the gate oxide **130** a conduction channel allowing the passage of current (electrons) between drain and source is formed in the p region. By properly biasing the drain contact region **115** and the source contact region **120** in such a way that the former is at an electric potential higher than that of the latter, the conduction channel is crossed by a flux of electrons flowing from the region at lower potential (the source contact region **120)** toward the region at higher potential (the drain contact region **115**).

An example of the path traveled by the electrons is illustrated in **Figure 1** with the reference **140.** As can be observed in the figure, the path **140** does not exhibit any hard change along the direction perpendicular to the surface **112,** and does not excessively penetrate in depth in the drain extension region **125,** substantially remaining parallel to the surface **112.** These features, due to the peculiarity of the shape and of the position of the additional insulating region **135,** may positively affect the electric characteristics of the conduction channel, which has a conduction resistance having a lower and more stable value compared to the values of the conduction resistances of the known DEMOS transistors **100** wherein the additional insulating regions are obtained by means of the STI technique. Particularly, the value of the conduction resistance of the proposed DEMOS transistor **100** may be lower than in the known cases, since the path **140** which the electrons traverse has fewer vertical portions (*i.e.,* along the direction perpendicular to the surface **112).** Moreover, the value of the conduction resistance may be more stable, since the lateral walls of the additional insulating region **135** are not totally perpendicular to the surface **112 -** and thus to the path **140** traveled by the electrons -, and consequently it is more difficult for an hot electron to succeed in injecting in the oxide of the additional insulating region **135.** Moreover, the hot-electrons injection may be hindered by the conformation assumed by the electric field lines generated by the non-perpendicular lateral walls, since such electric field lines tend to have a component that is transversal to the trajectory of the electrons, which tends to reject them from the additional insulating region **135.**

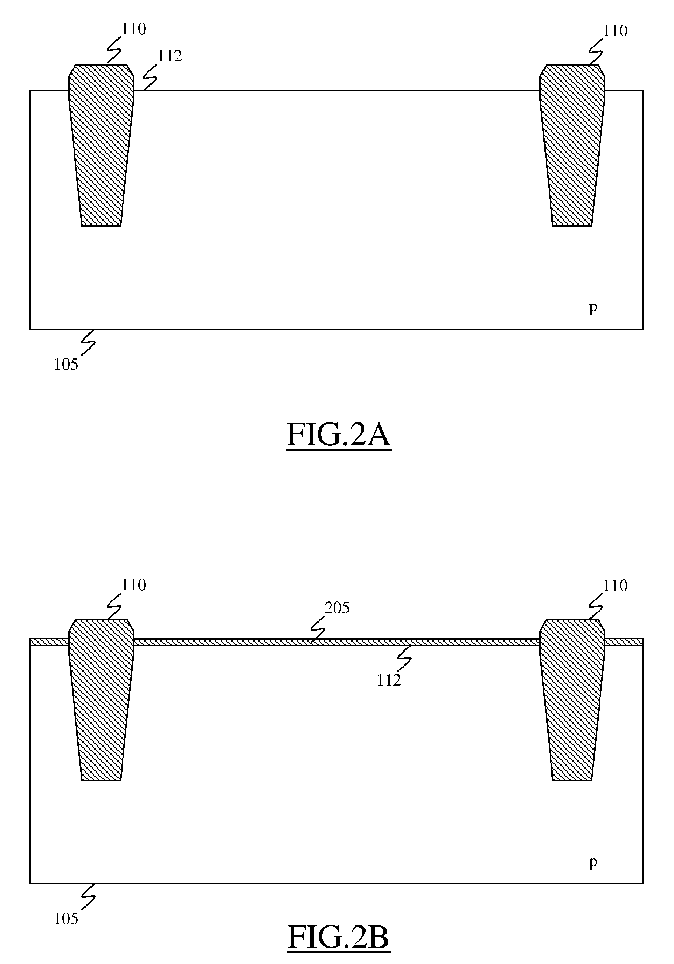

Making reference to the **Figures 2A - 2N****,** some phases of a process for manufacturing the DEMOS transistor **100** on a semiconductor chip according to an embodiment of the present invention will be now described. Typically, on a same chip of semiconductor material will be integrated also electronic devices of different type, such as for example MOS transistors for digital applications that manage low voltages or other components, both active and passive. In this regard, the phases which will be described in the following may be easily integrated in the process flux required for the production of the latter. Particularly, the phases illustrated in the **Figures 2A - 2N** are integrated in a manufacturing process which makes use of the STI technique for the formation of the insulating regions between adjacent devices, such as a standard CMOS fabrication process.

The **Figure 2A** schematically shows a sectional view of the portion **105** of the semiconductor material chip acting as a substrate for the DEMOS transistor **100** during a phase of the manufacturing process subsequent to the formation of the insulating regions **110.** The insulating regions **110** are formed by means of an STI technique, in the same way as the insulating regions for insulating the transistors formed by means of a standard CMOS manufacturing process are formed. The substrate **105** is characterized by a p-type conductivity, obtained by doping the silicon of the chip by means of atoms of an acceptor element.

In the subsequent phase, illustrated in **Figure 2B****,** a thin silicon dioxide layer **205** is deposited on the top surface **112** of the chip, for example by means of Chemical Vapor Deposition (CVD) or through a thermal oxidation process. The layer **205,** in jargon denoted protection oxide, is a protective layer which has the function of protecting the underlying substrate **105** from excessive stresses which may occur during the subsequent phases of the manufacturing process. According to an alternative embodiment of the present invention, instead of forming the protection oxide **205** by means of CVD, it is possible to reuse one of the oxide layers which have been employed during preceding process phases, which normally would be selectively removed. For example, since the insulating regions **110** have been formed by means of the STI technique, which may be carried out protecting the surface of the substrate by means of an oxide protective layer, such oxide protective layer, which normally is removed once the insulating regions are formed, may by also exploited as protection oxide **205** for the phases subsequent to that illustrated in **Figure 2B****.**

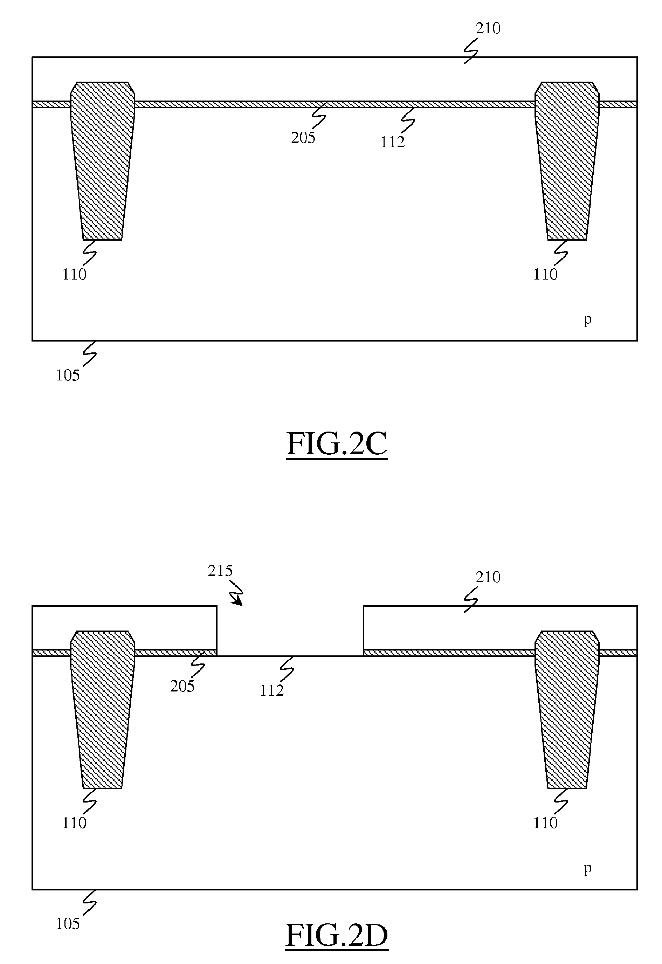

Then, as illustrated in **Figure 2C****,** a silicon nitride sacrificial layer **210** is deposited on the top surface of the chip by means of CVD, in such a way to cover both the protection oxide **205** and the insulating regions **110.**

At this point, a window is opened in the silicon nitride sacrificial layer **210** by means of the execution of lithographic masking and selective attacking operations. Particularly, as illustrated in **Figure 2D****,** by exploiting a dedicated mask (not shown in the figure), a portion of the silicon nitride sacrificial layer **210** located between the insulating regions **110** and the underlying portion of protection oxide **205** are attacked and removed for generating a window **215,** and for baring a corresponding portion of the top surface **112.** The previously described removal of the protection oxide **205** is an optional phase of the proposed embodiment, since such layer may be only partially removed or may be maintained thanks to the selectivity of the silicon nitride attack without compromising the formation of the global structure.

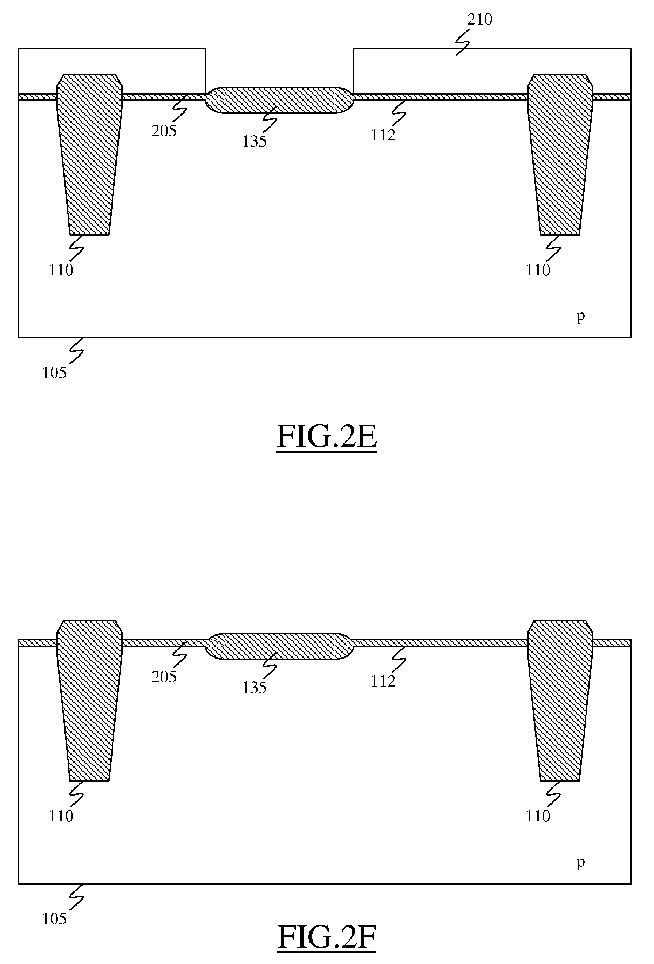

The window **215** is used for defining the additional insulating region **135** of the DEMOS transistor **135.** Particularly, the length of the window **215** determines the length of the additional insulating region **135;** such length may vary according to the voltage the DEMOS transistor **100** may have to manage during the operation. As illustrated in **Figure 2E****,** according to an embodiment of the present invention, the additional insulating region **135** is formed by means of thermal oxidation of the silicon forming the substrate **105.** Specifically, the chip is subjected to a Local Oxidation of Silicon (LOCOS) operation, by means of which the superficial surface of the substrate **105** which is not covered by the sacrificial layer **210** is oxidized, originating a silicon oxide layer which will constitute the additional insulating region **135** of the DEMOS transistor **100.** The presence of the protection oxide **205** may prevent the occurrence of possible defects in the substrate **105** caused by the unavoidable mechanical stresses (induced by the nitride layer deformation) to which the substrate **105** is subjected during the high temperature thermal treatment required for forming the insulating region **135.** The nitride layer **210** further prevents the oxidation of the substrate portions **105** close to the STI insulating regions, avoiding the occurrence of crystallographic defects which would result harmful for the whole operation of the transistor.

As it is known to the skilled technicians, by means of a conventional LOCOS technique, it is possible to generate a silicon oxide layer with a controlled thickness, which extends in depth in the substrate **105** by a relatively low amount. Thus, thanks to the proposed solution it is possible to form a relatively thin additional insulating region **135,** which extends in depth in the substrate **105** by a lower amount compared to an additional insulating region obtained by means of an STI technique. At the current technological state, an insulation region **135** obtained by means of the STI technique extends in depth in the substrate by a relatively high depth; forming instead the additional insulating region **135** by means of the LOCOS technique such in depth extension may be reduced to about one third. Since the proposed additional insulating region **135** is formed by means of the LOCOS technique, the lateral ends of the oxide layer which form the region exhibit a tapered shape - in jargon, "bird's beak". As already mentioned, such features of the additional insulating region **135** provides a DEMOS transistor provided with a better channel resistance, *i.e.,* more stable, having a lower value. Moreover, thanks to the proposed solution, the silicon portion underneath the additional insulating region **135** (and thus corresponding to a portion of the channel) is not subjected to excessive stress during the manufacturing process, since, unlike the STI technique, the LOCOS technique does not require the generation of trenches within the substrate. In this way, few to no interruptions are formed in the crystalline lattice, avoiding a significant negative affect on the carrier mobility.

Subsequently, as illustrated in **Figure 2F****,** the silicon nitride sacrificial layer **210** is totally removed. At this point, the manufacturing process may provide for the formation of n and p type wells by means of ionic implantation, usable for the formation of possible low voltage MOS transistors, bipolar transistors and passive components (not shown in the figure).

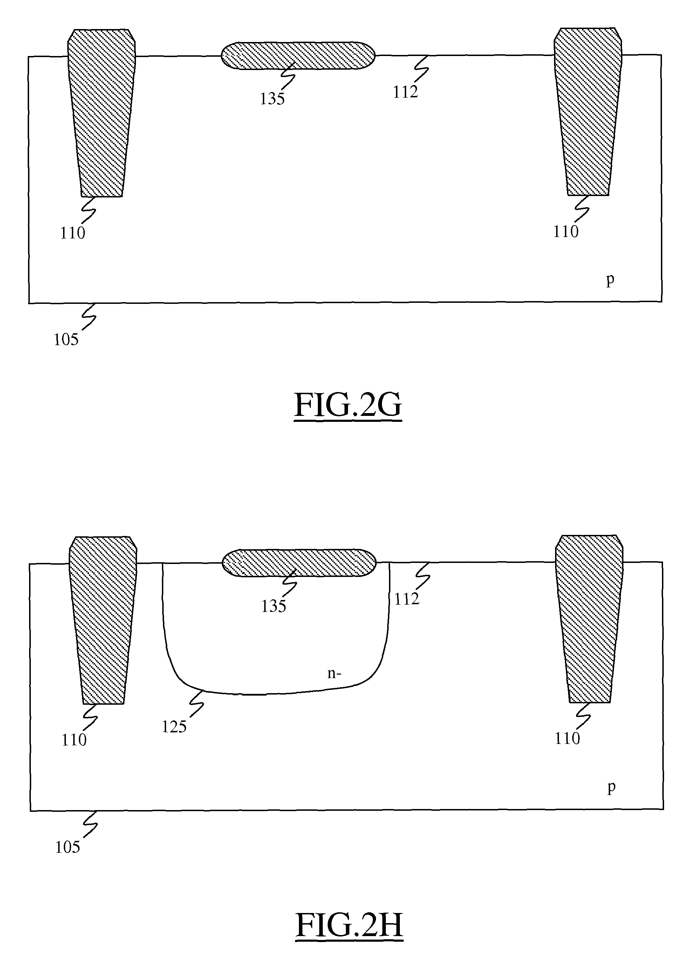

In the following phase, illustrated in **Figure 2G****,** the protection oxide **205** is completely removed.

As illustrated in **Figure 2H****,** once the protection oxide **205** has been removed, the drain extension region **125** may be defined in the substrate **105** portion underneath the additional insulating region **135,** for example by means of ionic implantation of a donor element. The formation of the drain extension region **125** may be also carried out in a different moment of the process flux, such as before the removal of the protection oxide **205.**

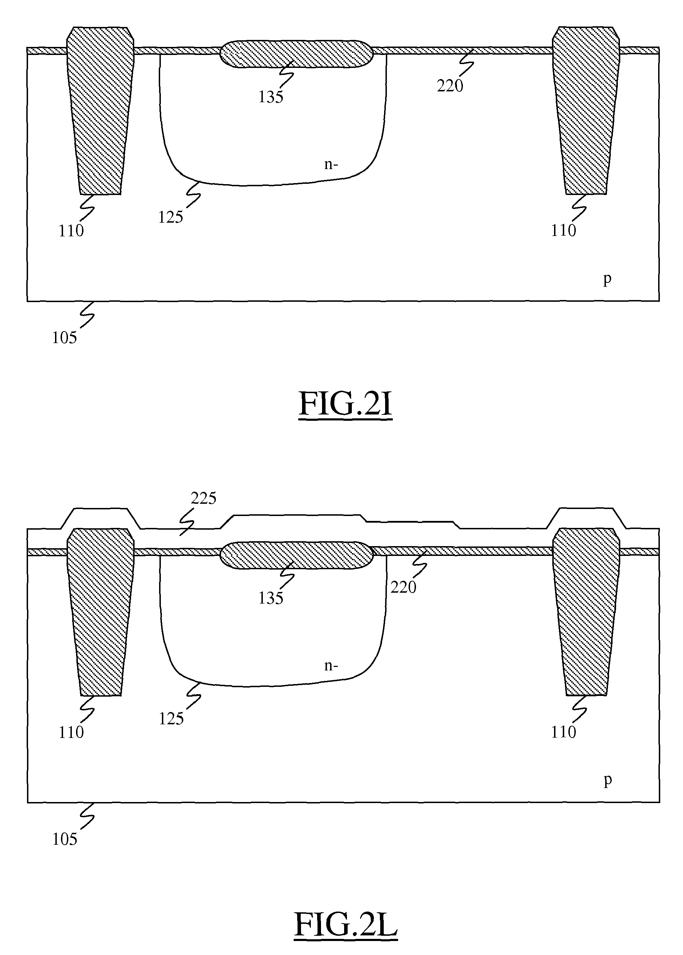

At this point, in order to complete the insulating element **127** of the DEMOS transistor **100** (see **Figure 1****)** it is necessary to proceed to the formation of the gate oxide **130.** The gate oxide **130** may be formed in the same way as the gate oxides for MOS transistors for low voltage applications are normally formed, *i.e.,* by growing (by means of a thermal oxidation process) an oxide layer of proper thickness on the surface of the chip - indicated in **Figure 2I** with the reference **220-,** and selectively etching such layer in a subsequent phase. Without descending into conventional details known to the skilled technicians, the final thickness of the gate oxide **130** may be obtained with a single oxidizing operation or with a proper sequence of oxidizing/masking operations, as in the manufacturing processes with diverse oxides.

Thanks to the previously described operations, it is possible to form an insulating element **127** having a differentiated thickness, as required for the correct operation of a DEMOS transistor for high power applications. Particularly, the thickness of the gate oxide **130** is determined by the thickness of the oxide layer **220** grown in the phase of the manufacturing process illustrated in **Figure 2I**, while the thickness of the additional insulating region **135** is determined by the characteristics of the oxidation process exploited in the phase illustrated in **Figure 2E****.**

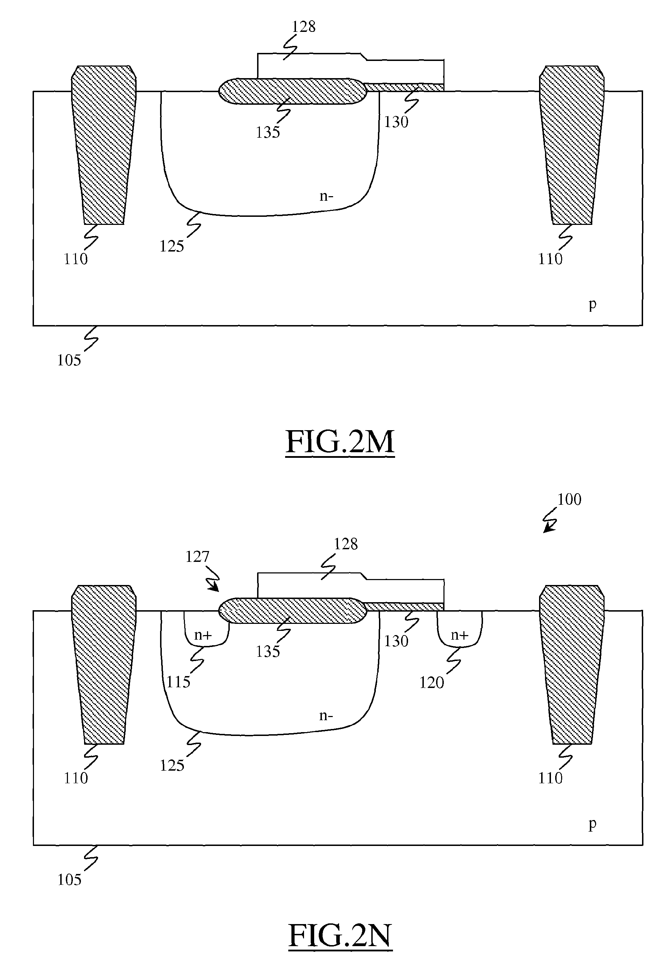

In the following phase, illustrated in **Figure 2L****,** the chip is covered by a semiconductor or conductor layer, such as polysilicon. The polysilicon layer **225** is then defined by means of masking operations, and subjected to selective etching operations. In this way there are defined both the gate electrode **128** and the underlying gate oxide **130,** as illustrated in **Figure 2M****.**

The **Figure 2N** illustrates the complete structure of the DEMOS transistor **100,** after the definition of the drain contact region **115** and of the source contact region **120.** The definition of such regions may be carried out at the same time of the definition of the drain and source contact regions of possible MOS transistors for low voltage applications which may be integrated in the same chip, and particularly carrying out ionic implantation of donor elements.

Although in the present description reference has been made to a process for manufacturing an n-channel DEMOS transistors, same considerations apply in the case of a p-channel DEMOS transistors, or in the case of a different MOS transistors for power applications adapted to manage high voltages, such as a DMOS or a DDMOS.

Concluding, according to an embodiment of the present invention, by means of the process phases illustrated in the **Figures 2A - 2N** it is possible to form an optimized DEMOS transistor which is not affected by the drawbacks normally affecting performances of the known DEMOS transistors formed by means of the advanced CMOS processes exploiting insulating techniques of the STI type. These process phases may be easily integrated into a standard CMOS integration process, without excessive costs. Particularly, starting from a standard CMOS integration process, it is sufficient to add the process phases illustrated in the **Figures 2C - 2G****,** which require the use of a single additional and dedicated mask, *i.e.,* the mask used for defining the portion of substrate to be subjected to local oxidation for generating the additional insulating region **135.**

Naturally, in order to satisfy local and specific requirements, a person skilled in the art may apply to the solution described above many modifications and alterations. Particularly, although the present invention has been described with a certain degree of particularity with reference to preferred embodiment(s) thereof, it should be understood that various omissions, substitutions and changes in the form and details as well as other embodiments are possible; moreover, it is expressly intended that specific elements and/or method steps described in connection with any disclosed embodiment of the invention may be incorporated in any other embodiment as a general matter of design choice.

## Claims

1. A method for forming a MOS transistor **(100)** for power applications in a substrate (105) of semiconductor material, said method being integrated in a process for manufacturing integrated circuits which uses an STI technique for forming the insulating regions, said method including the following phases:
- forming an insulating element **(127)** on a top surface **(112)** of the substrate;
- forming a control electrode **(128)** on a free surface of the insulating element, said insulating element insulating the control electrode from the substrate, wherein:
said insulating element comprises a first portion **(130)** and a second portion **(135),** the extension of the first portion along a first direction perpendicular to the top surface being lower than the extension of the second portion along said first direction,
**characterized in that:**
said phase of forming the insulating element comprises generating such second portion by locally oxidizing the top surface.

2. The method of claim 1, wherein the phase of generating the second portion comprises:
- forming a protective layer **(205)** on the top surface;
- depositing a sacrificial layer **(210)** on the protective layer;
- etching the sacrificial layer and the protective layer for uncovering a portion of the top surface, and
- oxidizing said uncovered portion of the top surface.

3. The method of claim 1 or 2, wherein such phase of forming the insulating element comprises generating such first portion performing the following phases:
- depositing an oxide layer **(220)** on the top surface, and
- selectively etching the oxide layer.

4. The method of any one among the preceding claims, wherein the substrate is formed by silicon of a first conductivity type, the process further including:
- forming in the substrate a drain region **(115)** of a second conductivity type opposed to the first conductivity type and a source region **(120)** of the second conductivity type, wherein:
- the drain region and the source region extend in the substrate from the top surface, and
- the first portion is adjacent to the source region, and the second portion is adjacent to the drain portion.

5. The method of claim 4, further including:
- before the formation of the drain region and the source region, forming a drain extension region **(125)** of the second conductivity type in the substrate, such forming the drain region comprising forming the drain region in the drain extension region.

6. The method of any one among the preceding claims, wherein said generating the second portion by locally oxidizing the top surface comprises executing an oxidizing operation by means of a LOCOS technique.

7. A MOS transistor **(100)** for power applications in a substrate **(105)** of semiconductor material, said transistor including:
- an insulating element **(127)** located on a top surface **(112)** of the substrate;
- a control electrode **(128)** located on the insulating element, said insulating element insulating the control electrode from the substrate, wherein:
said insulating element comprises a first portion **(130)** and a second portion **(135),** the extension of the first portion along a first direction perpendicular to the top surface being lower than the extension of the second portion along such first direction,
**characterized in that**:
said transistor is manufactured according to any one among the preceding claims.

8. The transistor of claim 7, wherein the substrate is formed by silicon of a first conductivity type, the transistor further including:
- a drain region **(115)** of a second conductivity type opposed to the first conductivity type and a source region **(120)** of the second conductivity type, and wherein:
- the drain region and the source region extend in the substrate from the top surface, and
- the first portion is adjacent to the source region, and the second portion is adjacent to the drain portion.

9. The transistor of claim 8, wherein the drain region is comprised within a drain extension region **(125)** of the second conductivity type, which extends in the substrate from the top surface.

10. The transistor of any one among claims 7-9, wherein said transistor is a transistor of the DEMOS type.

11. The transistor of any one among the claims 7 - 10, wherein the second portion exhibits a tapering in the proximity of a first and a second ends along a second direction perpendicular to the first direction.

12. A circuit integrated in a substrate of semiconductor material comprising a plurality of electronic devices, wherein said plurality of electronic devices comprises at least one MOS transistor for power application according to any one among claims 7 - 11.

13. The integrated circuit of claim 12, wherein the electronic devices of said plurality are electrically insulated by means of insulating regions formed by means of an STI technique.

14. The integrated circuit of claim 13, wherein:
- said insulating regions extend in the substrate along the first direction by a first amount, and
- the second portion of the insulating element of the at least one MOS transistor for power application extends in the substrate along the first direction by a second amount, said second amount being lower than said first amount.

15. The integrated circuit of claim 14, wherein the second amount is substantially equal to a third of the first amount.
